# EUROPEAN PATENT SPECIFICATION

(11) **EP 2 787 660 B1**
(45) Date of publication and mention of the grant of the patent: **27.09.2017**
(21) Application number: 13162171.6
(22) Date of filing: 03.04.2013
(51) Int. Cl.: H03K 5/01, H04B 10/58, H04B 10/50

(54) **Method for improving signal quality of a digital signal being transmitted through a non-linear device and apparatus using the same**
Verfahren zur Verbesserung der Signalqualität eines durch eine nichtlineare Vorrichtung gesendeten digitalen Signals sowie Vorrichtung damit
Procédé pour améliorer la qualité du signal d'un signal numérique étant transmis à travers un dispositif non linéaire et appareil l'utilisant

(43) Date of publication of application: 08.10.2014
(73) Proprietor: Cosemi Technologies Inc., Irvine, California 92614 (US)
(72) Inventor: Chacinski, Marek Grzegorz, 123 58 Farsta (SE); Chitica, Nicolae Pantazi, 16 471 Kista (SE)
(74) Representative: Grünecker Patent- und Rechtsanwälte PartG mbB

(56) References cited:
- DE-A1- 3 307 309
- US-A1- 2003 212 843
- US-A1- 2008 225 106
- US-A1- 2012 045 218
- US-B1- 6 373 346
- US-B1- 7 369 591

## Description

The present invention relates to a method for improving quality of a signal being transmitted at high speed through a non-linear electrical and / or optical device. The present invention also relates to an apparatus using this method.

Due to the high data rates in recently developed communication systems having data transmission rates of, for instance, 25 Gbps, signal integrity has become a major concern.

One cause of signal quality degradation is transmission of a signal through a bandwidth-limited channel, that is, one where the transmission is significantly lower above a certain frequency (the cutoff frequency). Passing a signal through such a channel results in attenuation of components at higher frequencies. This filtering of the transmitted signal affects the shape of the pulse that arrives at the receiver. Not only the shape of the pulse within its symbol period is changed, but it is also spread out over the subsequent symbol periods. When a signal is transmitted through such a channel, the spread pulse of each individual symbol will interfere with the following symbols.

The bandwidth limitation can be due to the physical properties of the active components or a medium; for instance, at bit rates of 25 Gbps, a copper cable, being used in an electrical link, may have a cutoff frequency above which practically none of the transmitted signals will propagate. Therefore, in order to provide sufficient bandwidth for high speed data transmission applications (for instance, at bit rates of 25 Gbps), optical links are proposed. Transmission of data over an optical link, however, involves conversion of electrical digital signals into optical signals.

A laser diode, such as a Vertical Cavity Surface Emitting Laser (VCSEL), is conventionally used for converting electrical signals into optical signals. However, the laser diode is a non-linear device, and therefore the laser diode affects the shape of its output pulse. Particularly, the pulse distortion can cause intersymbol interference.

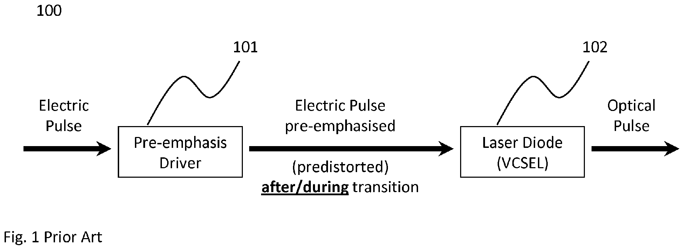

Figure 1 shows a schematic of a conventional transmitter for converting an electrical digital signal into an optical signal and outputting the optical signal to an optical fiber. The conventional transmitter 100 comprises a pre-emphasis driver 101 (that pre-distorts the signal) and a laser diode 102 connected to the pre-emphasis driver 101. The pre-emphasis driver 101 is adapted to receive at its input an electrical signal, to pre-emphasize the received signal, and to output pre-distorted electrical pulses. The laser diode 102 is adapted to receive at its input such electrical pulses from the pre-emphasis driver 101, to convert the received electrical pulses into optical signals, and to output the optical signals into the optical fiber (not shown in Fig. 1).

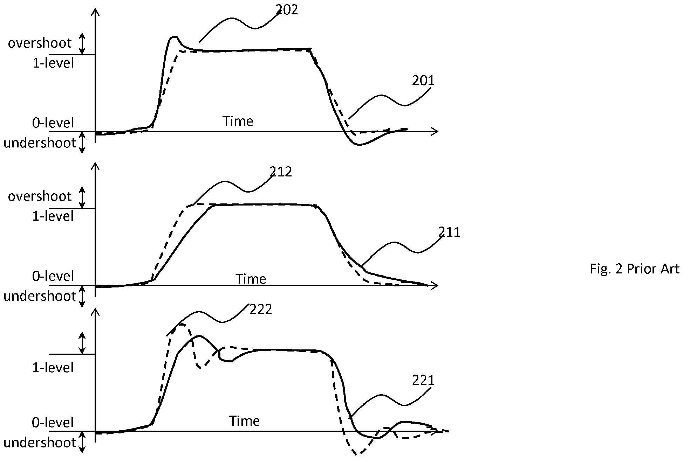

The pulse shaping performed by the pre-emphasis driver 101 of the conventional transmitter 100 is explained by means of Figure 2. The curve 201 represents the shape of a pulse of a digital (binary) signal input to the pre-emphasis driver 101. This pulse makes a first, positive transition from a lower level ("0"-level) to an upper level ("1 "-level), remains approximately constant at the upper level during the pulse lengths, and thereafter makes a second, negative transition from the upper level to the lower level. For clarity, the "1"-level is defined us the upper level, the "0"-level is defined us the lower level, a positive transition is defined as a transition from the lower level to the upper level, and a negative transition is defined as a transition from the upper level to the lower level of the signal. The curve 202 represents the shape of the signal output by the pre-emphasis circuit 101 when the square pulse 201 is applied to its input. This curve exhibits an overshoot immediately after the transition from "0"-level to "1"-level (the positive transition) and an undershoot immediately after the transition from "1"-level to "0"-level (the negative transition). Particularly, the curve 202 makes a transition from "0"-level to "1"-level, overshoots the "1 "-level, relaxes to the "1 "-level, makes a transition from "1 "-level to "0"-level, undershoots the "0"-level, and then relaxes to the "0"-level.

Hence, the pre-emphasis driver 101 of the conventional transmitter 100 is adapted to emphasize / peak an electrical digital signal during and / or immediately after the transition from one binary signal level to the other binary signal level.

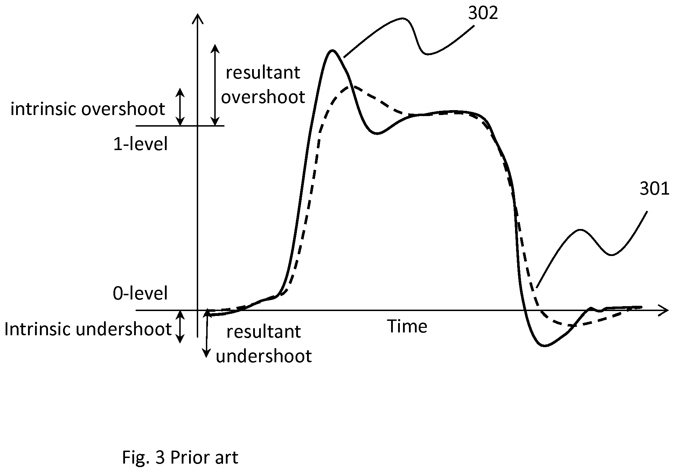

Figure 2 also shows the shape of the signal output by a bandwidth limited component being excited with a signal without such a pre-distortion and the shape of the signal output by the bandwidth limited component being excited with a signal having such a pre-distortion. Curve 212 exhibits more steep transitions between the lower and upper level compared to the curve 211. For the case of a non-linear device showing overshoot and ringing, when the pulse 201 and 202 are applied at its input, one will observe that the shape of the output signal looks like curve 221 and 222, respectively. Here, the pulse 222 exhibits shorter transition times (faster edges) compared to the pulse 221. In other words, pre-emphasis / peaking of the electrical pulse during and / or immediately after the transition from one binary signal level to the other binary signal level shortens the transition times at the edges of the pulse. The description of the behavior of the nonlinear component is detailed in Figure 3.

Figure 3 shows optical signals (in terms of optical power) output by the laser diode 102 when driven by the pre-emphasis driver 101. The curve 302 represents the shape of an optical pulse output by the laser diode 102, when an electrical pulse corresponding to curve 202 in Figure 2, that is an electrical pulse showing pre-emphasis during / after the transition from one binary level to the other, is applied at the input of the laser diode 102. The curve 301 represents the shape of an optical pulse output by the laser diode 102, when an electrical pulse corresponding to curve 201 of Figure 2, that is an electrical pulse without pre-emphasis, is applied at the input of the laser diode 102.

The curve 301 exhibits an overshoot after the transition from "0"-level to "1 "-level and an undershoot after the transition from "0"-level to "1 "-level. This overshoot/undershoot is due to the self-resonance (relaxation oscillation) of the laser diode 102, and therefore is intrinsic to the optical pulse output by the laser diode 102. Particularly, the curve 301 makes a transition from "0"-level to "1 "-level, overshoots the "1 "-level by the intrinsic overshoot, settles to the "1"-level, makes a transition from the "1"-level to the "0"-level, undershoots the "0"-level by the intrinsic undershoot, and then settles to the "0"-level.

Curve 302 of Figure 3 also exhibits an overshoot after the transition from "0"-level to "1"-level and an undershoot after the transition from "1"-level to "0"-level. The overshoot of curve 302 exceeds the intrinsic overshoot of the laser diode 102 by the overshoot that is induced by the pre-emphasized electrical pulse applied at the input of the laser diode 102. The undershoot of curve 302 exceeds the intrinsic undershoot of the laser diode 102 by the undershoot that is induced by the pre-emphasized electrical pulse applied at the input of the laser diode 102. Particularly, the curve 302 makes a transition from "0"-level to "1"-level, overshoots the "1 "-level by a resultant overshoot that is induced by both the intrinsic overshoot of the laser diode 102 and the overshoot of the pre-emphasized electrical input pulse, then relaxes to the "1"-level, makes a transition from "1"-level to "0"-level, undershoots the "0"-level by a resultant undershoot that is induced by both the intrinsic undershoot of the laser diode 102 and the undershoot of the pre-emphasized electrical input pulse, and then relaxes to "0"-level.

The effect of the pre-emphasis driver 101 on the optical signal output by the laser diode 102 becomes evident when comparing the curves 302 and 301 of Figure 3 to each other. This comparison shows that the transition times from one optical power level to another optical power level are shorter for curve 302. In other words, pre-emphasizing/peaking the input pulse of the laser diode 102 during and / or immediately after the transition from one binary level to the other binary level steepens the edges of the optical signal output by the laser diode.

However, the large overshoot of the optical pulse enhances the possibility of oscillations during the relaxation to the "1"-level. Also, the large undershoot of the optical pulse enhances the possibility of oscillation during the relaxation to the "0"-level. These relaxation oscillations prolong the time required for the stabilization of the optical signal around an optical power level. If, however, the pulse duration is too short to ensure stabilization (setting) of the optical signal, intersymbol interference may occur. This is detrimental to signal integrity of the optical signal.

Document US 2003/0212843 A1 discloses an apparatus for transmitting data from a source to a destination that is located a distance from the apparatus along a data bus. The apparatus comprising: a first driver for transmitting data along the data bus responsive to data being input thereto, the first driver producing data transitions between first and second driven logic states, the transitions having a first slope magnitude; a second driver connected in parallel with the first driver for selectively providing pre-emphasis to the data being transmitted by the first driver, whereby the slope of the transitions is increased at least during an initial portion of the transitions; and a data detector located upstream of the second driver for determining the transition history of data being input to the first driver and for activating the second driver as a function of the history.

Document US 2008/0225106 A1 shows a circuit for driving a plurality of light emitting units. The circuit comprising: an overshoot-current generating unit that generates an overshoot current; and a current adding unit that biases a light emitting current that is determined based on an amount of light emitted from each of the light emitting units with the overshoot current, and supplies resultant current to each of the light emitting units.

### SUMMARY OF INVENTION

It is an object of the present invention to provide a method for improving signal quality / integrity of a digital signal being transmitted through a non-linear device and / or a bandwidth-limited channel. It is also an object of the present invention to provide an apparatus using this method.

These objectives are achieved by the features as set forth in the independent claims. Further advantageous embodiments of the present invention are set forth in the dependent claims.

The present invention is based on the idea that pre-emphasizing a pulse of a digital (binary) signal before the transition / edge of the pulse effectively shortens the rise time and fall time of the pulse.

The present invention also recognizes that the optical pulse output by a laser diode in response to an electric pulse having pre-emphasis before its transitions has shorter transition times than the optical pulse output by a laser diode in response to an electric pulse having pre-emphasis after its transitions. Also, the optical pulse output in response to a pulse having pre-emphasis before its transitions has a better signal quality than the optical pulse output in response to a pulse having pre-emphasis after / during its transitions.

### BRIEF DESCRIPTION OF DRAWINGS

Fig. 1 shows a schematic of a conventional transmitter for converting an electrical digital signal into an optical signal;
Fig. 2 illustrates the pulse shaping performed by the pre-emphasis driver of the conventional transmitter; shapes of pulses after filtering by a bandwidth-limited component; and shapes of pulses after propagation over a nonlinear component;
Fig. 3 shows the shape of optical pulses output by the laser diode of the conventional transmitter in more details;
Fig. 4 shows a schematic of a transmitter in accordance with the present invention;
Fig. 5a shows the shape of a positive binary pulse input to the pre-emphasis driver of the transmitter of the present invention and the shape of the pulse output by the same in response to the positive binary input pulse;
Fig. 5b shows the shape of a negative binary pulse input to the pre-emphasis driver of the transmitter of the present invention and the shape of the pulse output by the same in response to the negative binary input pulse;
Fig. 5c shows the shape of positive four-level pulses input to the pre-emphasis driver of the transmitter of the present invention and the shape of the pulses output by the same in response to the positive four-level input pulses;
Fig. 5d shows the shape of negative four-level pulses input to the pre-emphasis driver of the transmitter of the present invention and the shape of the pulses output by the same in response to the negative four-level input pulse;
Fig. 6 shows the shape of an optical pulse output by a laser diode in response to a pulse output by the pre-emphasis driver of the transmitter of the present invention.

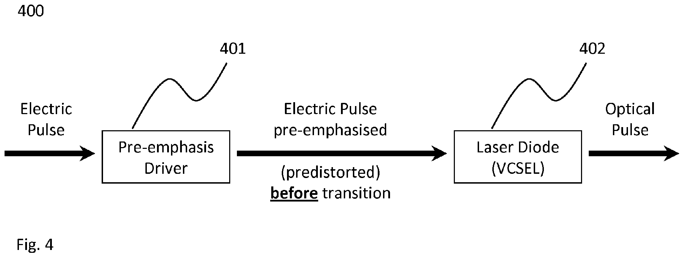

Referring now to Figure 4, an advantageous embodiment of the transmitter according to the present invention is shown. The transmitter 400 according to the present invention comprises a pre-emphasis driver 401 and a non-linear device 402 connected to the pre-emphasis driver 401. The pre-emphasis driver 401 is adapted to receive at its input an electrical digital signal including at least one (binary) pulse, to pre-emphasize / peak the received electrical digital signal, and to output a pre-emphasized electrical digital signal. The non-linear device 402 is adapted to receive at its input the pre-emphasized electrical digital signal outputted by the pre-emphasis driver 401, to process the received signal, and to output a digital signal into a transmission medium (not shown in Fig. 4). The non-linear device 402 is any one of a laser diode, a light-emitting diode, a transistor and an amplifier. Depending on the non-linear device 402 used, the digital signal output by the non-linear device 402 is either an electric signal or an optical signal.

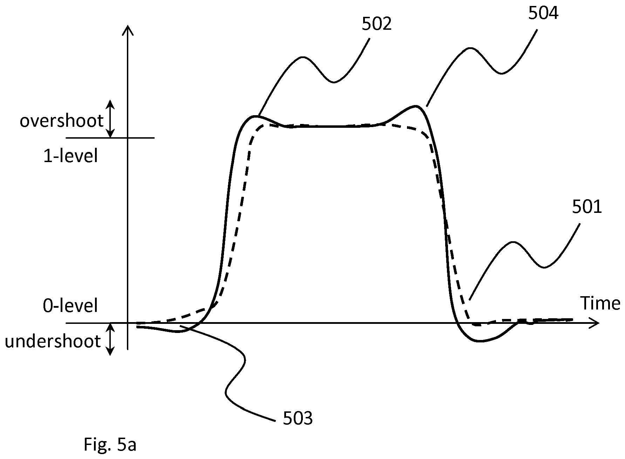

Referring now to Figures 5a to 5d, the effect of the pre-emphasis driver 401 on the received electrical digital signal is explained:
In Figure 5a the curve 501 represents the shape of a pulse of a digital (binary) signal input to the pre-emphasis driver 401. This pulse makes a first, positive transition from a lower level ("0"-level) to an upper level ("1 "-level), remains approximately constant at the upper level for the duration of the pulse, and thereafter makes a second, negative transition from the upper level to the lower level. The curve 502 represents the shape of the signal output by the pre-emphasis circuit 401 in response to the pulse 501. This curve exhibits an undershoot immediately before (or next to) the positive transition from the lower level to the upper level and an overshoot immediately before (or next to) the negative transition from the upper level to the lower level. Particularly, the curve 502 undershoots the lower level by the undershoot 503, makes a first transition from the lower level to the upper level, stays approximately constant at the upper level, overshoots the upper level by the overshoot 504, makes a second transition from the upper level to the lower level, and then stays approximately constant to the lower level.

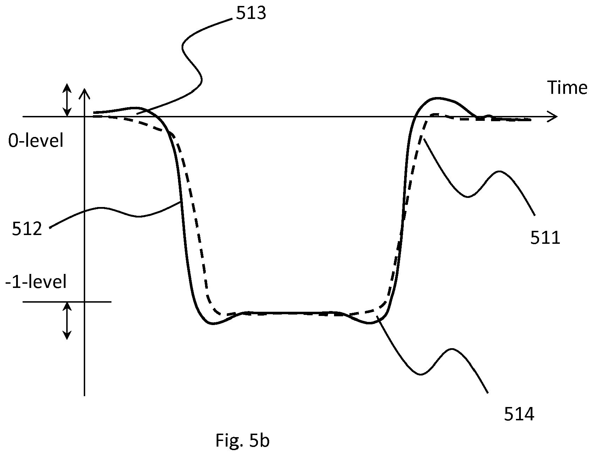

The pulse 501 shown in Figure 5a is a particular case chosen for clarity. However, the present invention is not limited to this case, but is also applicable to the inverted pulse 511 shown in Fig. 5b. This pulse starts at an upper level ("0"-level), makes a first, negative transition from the upper level to a lower level ("-1 "-level), remains approximately constant at the lower level during the pulse length, and thereafter makes a second, positive transition from the lower level to the upper level. Curve 512 in Figure 5b represents the shape of the signal output by an pre-emphasis circuit according to the present invention in response to the pulse 511. This curve exhibits an overshoot immediately before (or next to) the negative transition from the upper level to the lower level and an undershoot immediately before (or next to) the positive transition from the lower level to the upper level. Particularly, the curve 512 overshoots the upper level ("0"-level) by the overshoot 513, makes a first transition from the upper level to the lower level ("-1"-level), stays approximately constant at the lower level, undershoots the lower level ("-1"-level) by the undershoot 514, makes a second transition from the lower level to the upper level, and then stays approximately constant at the upper level.

Moreover, the pulse does not need to be part of a sequence of pulses. The present invention also applies to a single pulse signal, also called monopulse.

The pre-emphasis driver 401 of the transmitter 400 is adapted to emphasis / peak a (binary) signal level of an electric digital signal immediately before the transition from one binary signal level to the other binary signal level.

**Table 1**

| Parameter | Without pre-emphasis | Pre-emphasis after the transition | Pre-emphasis before the transition |
|---|---|---|---|
| Overshoot [%] | 6.0 | 16.9 | 6.4 |
| Rise Time [ps] | 14.7 | 13.4 | 12.8 |
| Fall Time [ps] | 15.7 | 14.3 | 13.3 |
| Eye Opening Factor | 0.84 | 0.64 | 0.59 |

The effect of the pre-emphasis driver 401 becomes evident from Table 1. This table indicates: parameters of the pulse 203 output by a non-linear device in response to a square pulse 201 (without pre-emphasis), parameters of the pulse 202 output by the conventional pre-emphasize driver 101 (pre-emphasis after the transition) in response to the input pulse 201, and parameters of the pulse 502 output by the pre-emphasize driver 401 (pre-emphasis before the transition) in response to the input pulse 501. The following parameters are indicated: the overshoot beyond the "1 "-level; the rise time of the transition from "0"-level to "1 "-level; the fall time of the transition from "1 "-level to "0"-level; and the eye opening factor. The eye opening factor relates to the eye diagram of the digital signal including the respective pulses and is equal to the ratio between inner eye opening (eye height) and eye amplitude.

Table 1 shows that the output pulse 502 of the pre-emphasize driver 401 has the shortest rise time and the shortest fall time. This performance is achieved with an overshoot that is significantly lower than the overshoot induced by the conventional pre-emphasis driver. As the overshoot of the output pulse 502 of the pre-emphasize driver 401 is much lower than the overshoot of the output pulse 202 of the conventional pre-emphasize driver 101, the possibility of unwanted enhancement of relaxation oscillations is much lower in the output pulse 502 of the pre-emphasize driver 401 than in the output pulse 202 of the conventional pre-emphasize driver 201. Furthermore, Table 1 shows that the digital signal output by the pre-emphasize driver 401 and the digital signal output by the conventional pre-emphasize driver 201 have comparable eye opening factors, i.e., the short transition times of the output pulse of the pre-emphasis driver 401 are not achieved at the expense of less signal quality.

In Fig. 5a, which shows the output signal of the pre-emphasis driver included in a transmitter according to a first preferred embodiment of the present invention, the undershoot applied to the "0"-level is immediately before (or next to) the first (positive) transition of the pulse 502, and the overshoot applied to the "1 "-level is immediately before the second (negative) transition of the pulse 502. However, the present invention is not limited to this embodiment. Also the following embodiments are conceivable: i) only an undershoot is applied to the "0"-level immediately before the first transition of the pulse 502, but no overshoot is applied to the "1 "-level immediately before the second transition of the pulse 502; and ii) only an overshoot is applied to the "1 "-level immediately before the second transition of the pulse 502, but no undershoot is applied to the "0"-level immediately before the first transition of the pulse 502.

Furthermore, it is not mandatory for the present invention that the undershoot applied to the lower level is immediately before the first transition of pulse 502 and that the overshoot applied to the upper level is immediately before the second transition of pulse 502. It is rather sufficient that the undershoot applied to the lower level before the first transition of pulse 502 is closer to the first transition of the pulse 502 than to the second transition of a pulse preceding pulse 502, and/or that the overshoot applied to the upper level before the second transition of pulse 502 is closer to the second transition of pulse 502 than to the first transition of pulse 502.

In Figure 5b, which shows the output signal of the pre-emphasis driver included in a transmitter according to the second preferred embodiment of the present invention, the overshoot applied to the upper level ("0"-level) is immediately before (or next to) the first (negative) transition of the pulse 512, and the undershoot applied to the lower level ("-1"-level) is immediately before the second (positive) transition of the pulse 512. However, the present invention is not limited to this embodiment. Also the following embodiments are conceivable: i) only an overshoot is applied to the upper level ("0"-level) immediately before the first transition of the pulse 512, but no undershoot is applied to the lower level ("-1"-level) immediately before the second transition of the pulse 512; and ii) only an undershoot is applied to the lower level ("-1"-level) immediately before the second transition of the pulse 512, but no overshoot is applied to the upper level ("0"-level) immediately before the first transition of the pulse 512.

Furthermore, it is not mandatory for the present invention that the overshoot applied to the upper level is immediately before the first transition of pulse 512 and that the undershoot applied to the lower level is immediately before the second transition of pulse 512. It is rather sufficient that the overshoot applied to the upper level before the first transition of pulse 512 is closer to the first transition of the pulse 512 than to the second transition of a pulse preceding pulse 512, and/or that the undershoot applied to the lower level before the second transition of pulse 512 is closer to the second transition of pulse 512 than to the first transition of pulse 512.

In Figure 5a and 5b only pulses making a transition from a first level to a second level and vice versa are shown. However, the present invention is not limited to a binary (two-level) digital signal, but also applies to a digital signal with more than two-levels, also known as multi-level signal.

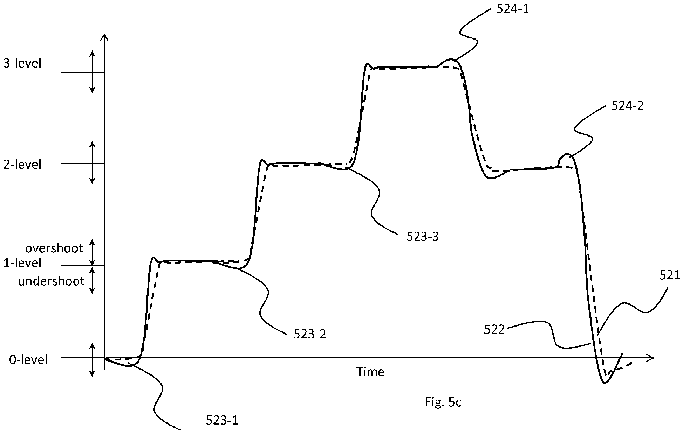

Curve 521 of Figure 5c shows the shape of four pulses of a four-level digital signal input to the pre-emphasis driver included in a transmitter according to a third embodiment of the present invention. This signal makes a first transition from a first level ("0"-level) to a second level ("1"-level), which is higher than the first level, remains approximately constant at the second level for the duration of the pulse, thereafter makes a second transition from the second level to a third level ("2"-level), which is higher than the second level, remains approximately constant at the third level for the duration of the pulse, thereafter makes a third transition from the third level to a fourth level ("3"-level), which is higher than the third level, remains approximately constant at the fourth level for the duration of the pulse, thereafter makes a fourth transition from the fourth level to the third level, remains approximately constant at the third level for the duration of the pulse, and thereafter makes a fifth transition from the third level to the first level. The curve 522 represents the shape of the signal output by the pre-emphasis circuit included in the transmitter according to the third embodiment of the present invention in response to the fourth-level digital signal 521. This curve exhibits an undershoot immediately before (or next to) the positive transitions, i.e. the transitions from a lower level to a higher level, and an overshoot immediately before (or next to) the negative transitions. i.e. the transitions from a higher level to a lower level. Particularly, the curve 522 undershoots the first level ("0"-level) by an undershoot 523-1, makes a first transition from the first level to the second level ("1 "-level), stays approximately constant at the second level, thereafter undershoots the second level by an undershoot 523-2, makes a second transition from the second level to the third level ("2"-level), stays approximately constant at the third level, thereafter undershoots the third level by an undershoot 523-3, makes a third transition from the third level to the fourth level ("3"-level), stays approximately constant at the fourth level, overshoots the fourth level by the overshoot 524-1, makes a fourth transition from the fourth level to the third level, stays approximately constant to the third level, and thereafter overshoots the third level by the overshoot 524-2, and makes a fifth transition from the third level to the first level.

The four levels of the four-level digital signal shown in Fig. 5c have a positive polarity. However, the present invention is not limited to four-level digital signals whose levels are positive. Moreover, the present invention is also applicable to four-level digital signals whose levels have a negative polarity.

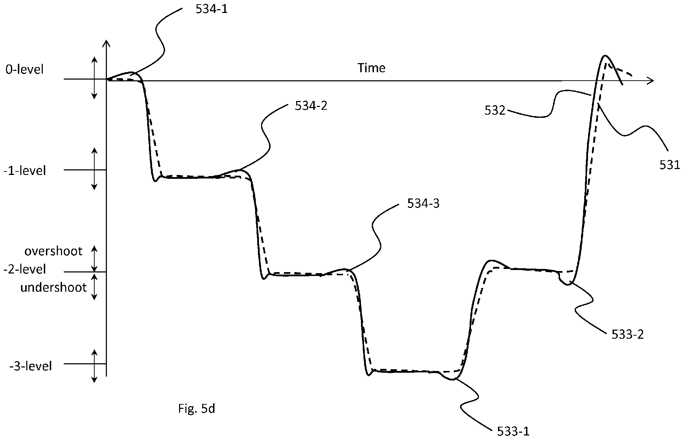

For example, curve 531 of Figure 5d shows the shape of four pulses of a four-level digital signal input to the pre-emphasis driver included in a transmitter according to a fourth embodiment of the present invention. This signal makes transitions between a first level ("0"-level), a second level ("-1 "-level), which is lower than the first level, a third level ("-2"-level), which is lower than the second level, and a fourth level ("-3"-level), which is lower than the third level. The first, second, third and fourth level have a negative polarity. The curve 532 represents the shape of the signal output by the pre-emphasis circuit included in the transmitter according to the fourth embodiment of the present invention in response to the fourth-level digital signal 531. This curve exhibits an undershoot 534-1 and 534-2 immediately before (or next to) the positive transitions, i.e. the transitions from a lower level to a higher level, and an overshoot 533-1, 533-2 and 533-3 immediately before (or next to) the negative transitions. i.e. the transitions from a higher level to a lower level.

In Figs. 5c and 5d the four levels of the four-level digital signal have the same polarity. However, the present invention is not limited to four-level digital signals whose levels have the same polarity. Moreover, the present invention is also applicable to four-level digital signals whose levels have different polarities.

The four-level digital signals shown in Figures 5c and 5d are only examples of multi-level digital signals to which the present invention applies and the scope of the present invention is not limited to them. Moreover, the present invention is applicable to any multi-level digital signal having an arbitrary number of levels, making transitions between any two levels of the digital signal, and making an arbitrary number of (positive and / or negative) transitions between two levels of the digital signal.

Hence, a transmitter according to the present invention is adapted to process a digital signal having a plurality of levels m and which makes one or a plurality of transitions n between any two levels of the plurality of levels. m and n are natural numbers, m is greater or equal 2, and n is greater or equal 1. The transmitter according to the present invention includes a pre-emphasize driver which is adapted to emphasize / peak a level of the digital signal (immediately) before the transition from one, first level to another, second level of the plurality of levels. In particular, the pre-emphasize driver is adapted to pre-emphasize the digital signal by applying an undershoot to the first level (immediately) before the transition, when the first level is lower than the second level (i.e. at a positive transition), and to pre-emphasize the digital signal by applying an overshoot to the first level (immediately) before the first transition, when the first level is higher than the second level (i.e. at a negative transition).

A fifth preferred embodiment of the present invention differs from the first preferred embodiment in that the non-linear device is a laser diode (for instance, a VCSEL). The fifth preferred embodiment converts electrical input pulses into optical output pulses. When the rise time and fall time of the input pulse are too large, the laser diode can spread out the optical output pulse over the subsequent symbol period, which causes intersymbol distortion. The conventional method of pre-emphasizing the electrical input pulse shortens the rise time and fall time of the input pulse. However, the conventional method causes a high overshoot and undershoot in the optical output pulse (cf. Figure 3), which also can cause intersymbol interference. In view of this drawback, a method for pre-emphasizing the electrical input pulse that shortens the rise time and fall time of the optical output pulse, but does not significantly increase the overshoot and undershoot of the optical output pulse is preferable.

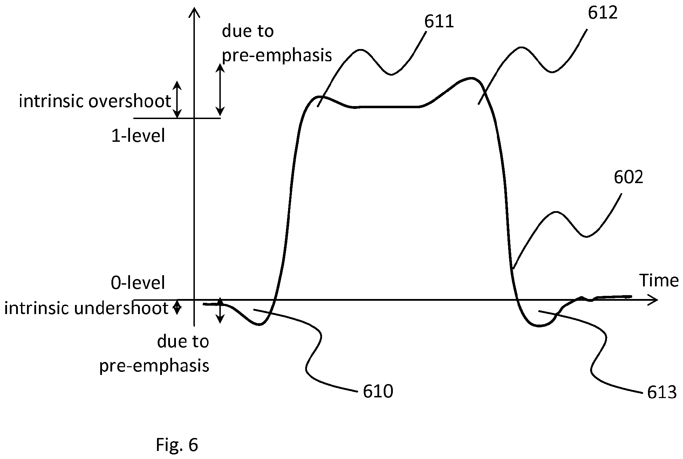

Figure 6 and Table 2 show that the present invention achieves this aim.

Curve 602 in Figure 6 represents the optical power emitted by the laser diode in response to the electrical pulse 502 shown in Figure 5. The curve 602 exhibits a first undershoot 610 before the transition from "0"-level to "1 "-level, a first overshoot 611 after the transition from "0"-level to "1"-level, a second overshoot 612 before the transition from "1"-level to "0"-level, and a second undershoot 613 after the transition from "1 "-level to "0"-level. The first undershoot 610 is due to the undershoot 503 of the input pulse 502. The first overshoot 611 is mainly due to the intrinsic overshoot (relaxation oscillations) of the laser diode. The second overshoot 612 is due to the overshoot 504 of the input pulse 502. The second undershoot 613 is mainly due to the intrinsic undershoot (relaxation oscillations) of the laser diode. Particularly, the curve 602 undershoots the "0"-level by the first undershoot 610, makes a transition from "0"-level to "1 "-level, overshoots the "1 "-level by the first overshoot 611, relaxes to the "1 "-level, overshoots the "1 "-level again by the second overshoot 612, makes a transition from "1 "-level to "0"-level, undershoots the "0"-level by the second undershoot 613, and then relaxes to "0"-level.

**Table 2**

| Parameter | Without pre-emphasizing | Pre-emphasis after the transition | Pre-emphasis before the transition |
|---|---|---|---|
| Overshoot [%] | 11.4 | 19.0 | 15.5 |
| Rise Time [ps] | 23.6 | 21.1 | 19.4 |
| Fall Time [ps] | 30.0 | 27.3 | 26.5 |
| Eye Opening Factor | 0.26 | 0.30 | 0.45 |
| Number of mask hits | 27 | 45 | 4 |

Table 2 indicates: parameters of the optical pulse output by the laser diode in response to the pulse 203 shown in Figure 2 (without pre-emphasis), parameters of the optical pulse output by the laser diode in response to the pulse 202 of Figure 2 (pre-emphasis during / after the transition), and parameters of the optical pulse output by the laser diode in response to the pulse 502 of Figure 5 (pre-emphasis before the transition). The following parameters are indicated: the overshoot of the optical signal beyond the "1 "-level; the rise time of the transition from "0"-level to "1 "-level; the fall time of the transition from "1 "-level to "0"-level; the eye opening factor; and the number of mask hits.

Table 2 shows that the optical pulse output by the fifth preferred embodiment of the present invention has the shortest rise time and the shortest fall time. These transition times are achieved at an overshoot beyond the "1"-level which is much lower than the overshoot beyond the "1 "-level of the optical pulse output by the laser diode in response to pulse 202 of Fig. 2 (showing pre-emphasis after the transition). Having a smaller overshoot beyond the "1 "-level, the optical pulse output by the fifth preferred embodiment of the present invention is less susceptible to relaxation oscillations than the optical pulse output by the conventional transmitter shown in Figure 1.

Furthermore, Table 2 shows that the optical pulse output by the laser diode of the fifth preferred embodiment of the present invention achieves the highest eye opening factor and the lowest number of mask hits. Thus, the fifth preferred embodiment of the present invention not only shortens the rise time and the fall time of the optical output pulse 602 but also improves its signal quality.

As the present invention improves signal quality, particularly contributes to the reduction of intersymbol interference, it is especially suited in communication systems having high data transmission rates, such as 25 Gbps.

**Reference Numerals**

| **Reference Numeral** | **Description** |
|---|---|
| 100 | Conventional transmitter |
| 101 | Pre-emphasis driver of the conventional transmitter |
| 102 | Laser diode of the conventional transmitter |
| 201 | Electrical pulse input to the conventional pre-emphasis driver |
| 202 | Electrical pulse output by the conventional pre-emphasis driver |
| 211 | Electrical pulse output by a bandwidth limiting component excited with pulse 201 |
| 212 | Electrical pulse output by a bandwidth limiting component excited with pulse 202 |
| 221 | Electrical pulse output by a non-linear electrical device excited with pulse 201 |
| 222 | Electrical pulse output by a non-linear electrical device excited with pulse 202 |
| 301 | Optical pulse output by the laser diode of the conventional transmitter in response to an (ideal) square input signal |
| 302 | Optical pulse output by the laser diode of the conventional transmitter in response to an pre-emphasized input signal |
| 400 | Transmitter of the present invention |
| 401 | Pre-emphasis driver according to the present invention |
| 402 | Non-linear device, e.g. transistor or laser diode |
| 501, 511, 521, 531 | Electrical pulse(s) input to the pre-emphasis driver |
| 502, 512, 522, 532 | Electrical pulse(s) output by the pre-emphasis driver |
| 503, 513, 523, 533 | Undershoot of a level |
| 504, 514, 524, 534 | Overshoot of the a level |
| 602 | Optical pulse output by the laser diode of a transmitter of the present invention |
| 610 | First undershoot of the optical output pulse |
| 611 | First overshoot of the optical output pulse |
| 612 | Second overshoot of the optical output pulse |
| 613 | Second undershoot of the optical output pulse |

## Claims

1. A method for processing a digital signal through a non-linear device, the digital signal making a first transition from a first level to a second level, the method comprising:
a step of pre-emphasizing the digital signal; and
a step of processing the pre-emphasized digital signal by the non-linear device;
**characterized in that** the step of pre-emphasizing the digital signal includes:
pre-emphasizing the digital signal by applying an undershoot (503) to the first level before the first transition, when the first level is lower than the second level; and/or
pre-emphasizing the digital signal by applying an overshoot (513) to the first level before the first transition, when the first level is higher than the second level.

2. The method according to claim 1, wherein the digital signal further makes a second transition, following the first transition, from the second level to a third level, and
the step of pre-emphasizing the digital signal further includes:
pre-emphasizing the digital signal by applying an overshoot (504, 534-2) to the second level before the second transition, when the second level is higher than the third level; and/or
pre-emphasizing the digital signal by applying an undershoot (514, 523-2) to the second level before the second transition, when the second level is lower than the third level.

3. The method according to claim 2, wherein the first level is different from the third level.

4. The method according to claim 2, wherein the first level coincides to the third level.

5. The method according to claim 3 or 4, wherein the digital signal further makes a third transition, preceding the first transition, from a fourth level to the first level,
when the first level is lower than the second level, the undershoot applied to the first level before the first transition is closer to the first transition than to the third transition,
when the first level is lower than the second level, the overshoot applied to the second level before the second transition is closer to the second transition than to the first transition,
when the first level is higher than the second level, the overshoot applied to the first level before the first transition is closer to the first transition than to the third transition, and
when the first level is higher than the second level, the undershoot applied to the second level before the second transition is closer to the second transition than to the first transition.

6. The method according to any of claims 1 to 5, wherein the undershoot applied to the first level is immediately before the first transition, or
the undershoot applied to the second level is immediately before the second transition, or
the overshoot applied to the second level is immediately before the second transition, or
the overshoot applied to the first level is immediately before the first transition.

7. The method according to any of claims 1 to 6, wherein all of the first level, the second level and the third level have the same polarity.

8. The method according to any of claims 1 to 6, wherein one level of the first level, the second level and the third level has a first polarity and another level of the first level, the second level and the third level has a second polarity different from the first polarity.

9. The method according to any one of claims 1 to 8, wherein the non-linear device is any one of either a laser diode (402), a light-emitting diode, a photo diode, a transistor or an amplifier.

10. Apparatus for processing a digital signal through a non-linear device, the digital signal making a first transition from a first level to a second level, the apparatus comprising:
a pre-emphasize driver (401) for pre-emphasizing the digital signal; and
a non-linear device (402) for processing the pre-emphasized digital signal output by the pre-emphasize driver (401);
**characterized in that**
the pre-emphasize driver (401) is adapted to pre-emphasize the digital signal by applying an undershoot (503) to the first level before the first transition, when the first level is lower than the second level; and/or
to pre-emphasize the digital signal by applying an overshoot (513) to the first level before the first transition, when the first level is higher than the second level.

11. The apparatus according to claim 10, wherein the digital signal further makes a second transition, following the first transition, from the second level to a third level, and
the pre-emphasize driver (401) is further adapted to pre-emphasize the digital signal by applying an overshoot (504, 534-2) to the second level before the second transition, when the second level is higher than the third level; and/or
to pre-emphasize the digital signal by applying an undershoot (514, 523-2) to the second level before the second transition, when the second level is lower than the third level.

12. The apparatus according to claim 11, wherein the first level is different from the third level.

13. The apparatus according to claim 11, wherein the first level coincides to the third level.

14. The apparatus according to claim 12 or 13, wherein the digital signal further makes a third transition, preceding the first transition, from a fourth level to the first level,
when the first level is lower than the second level, the undershoot applied to the first level before the first transition is closer to the first transition than to the third transition,
when the first level is lower than the second level, the overshoot applied to the second level before the second transition is closer to the second transition than to the first transition,
when the first level is higher than the second level, the overshoot applied to the first level before the first transition is closer to the first transition than to the third transition, and
when the first level is higher than the second level, the undershoot applied to the second level before the second transition is closer to the second transition than to the first transition.

15. The apparatus according to any of claims 10 to 14, wherein the undershoot applied to the first level is immediately before the first transition, or
the undershoot applied to the second level is immediately before the second transition, or
the overshoot applied to the second level is immediately before the second transition, or
the overshoot applied to the first level is immediately before the first transition.

16. The apparatus according to any of claims 11 to 15, wherein all of the first level, the second level and the third level have the same polarity.

17. The apparatus according to any of claims 11 to 15, wherein one level of the first level, the second level and the third level has a first polarity and another level of the first level, the second level and the third level has a second polarity different from the first polarity.

18. The apparatus according to any one of claims 10 to 17, wherein the non-linear device is any one of either a laser diode (402), a light-emitting diode, a photo diode, a transistor or an amplifier.

19. A transmitter (400) for transmitting a digital signal over a transmission medium including the apparatus according to any of claims 10 to 18.

20. The transmitter according to claim 19, wherein the non-linear device (402) is a laser diode and the transmission medium is an optical fiber.

21. A communication system including the transmitter according to claim 19 or 20.

## Patentansprüche

1. Verfahren zur Verarbeitung eines digitalen Signals durch eine nicht-lineare Einrichtung, wobei das digitale Signal einen ersten Übergang von einem ersten Pegel zu einem zweiten Pegel durchläuft, wobei das Verfahren umfasst:
einen Schritt zur Voranhebung des digitalen Signals; und
einen Schritt zur Verarbeitung des vor-angehobenen digitalen Signals durch die nicht-lineare Einrichtung;
**dadurch gekennzeichnet, dass** der Schritt der Voranhebung des digitalen Signals umfasst:
Voranheben des digitalen Signals durch Anwendung einer Unterschwingung (503) auf den ersten Pegel vor dem ersten Übergang, wenn der erste Pegel niedriger als der zweite Pegel ist; und/oder
Voranheben des digitalen Signals durch Anwendung einer Überschwingung (513) auf den ersten Pegel vor dem ersten Übergang, wenn der erste Pegel höher als der zweite Pegel ist.

2. Verfahren nach Anspruch 1, wobei das digitale Signal ferner einen zweiten Übergang im Anschluss an den ersten Übergang von dem zweiten Pegel zu einem dritten Pegel durchläuft, und
der Schritt der Voranhebung des digitalen Signals ferner umfasst:
Voranheben des digitalen Signals durch Anwendung einer Überschwingung (504, 534-2) auf den zweiten Pegel vor dem zweiten Übergang, wenn der zweite Pegel höher als der dritte Pegel ist; und/oder
Voranheben des digitalen Signals durch Anwenden einer Unterschwingung (514, 523-2) auf den zweiten Pegel vor dem zweiten Übergang, wenn der zweite Pegel niedriger als der dritte Pegel ist.

3. Verfahren nach Anspruch 2, wobei der erste Pegel sich von dem dritten Pegel unterscheidet.

4. Verfahren nach Anspruch 2, wobei der erste Pegel mit dem dritten Pegel übereinstimmt.

5. Verfahren nach Anspruch 3 oder 4, wobei das digitale Signal ferner einen dritten Übergang vor dem ersten Übergang von einem vierten Pegel zu dem ersten Pegel durchläuft,
wenn der erste Pegel niedriger als der zweite Pegel ist, ist die auf den ersten Pegel vor dem ersten Übergang angewendete Unterschwingung näher an dem ersten Übergang als an dem dritten Übergang,
wenn der erste Pegel niedriger als der zweite Pegel ist, ist die vor dem zweiten Übergang auf den zweiten Pegel angewendete Überschwingung näher an dem zweiten Übergang als an dem ersten Übergang,
wenn der erste Pegel höher als der zweite Pegel ist, ist die vor dem ersten Übergang auf den ersten Pegel angewendete Überschwingung näher an dem ersten Übergang als an dem dritten Übergang, und
wenn der erste Pegel höher als der zweite Pegel ist, ist die vor dem zweiten Übergang auf den zweiten Pegel angewendete Unterschwingung näher an dem zweiten Übergang als an dem ersten Übergang.

6. Verfahren nach einem der Ansprüche 1 bis 5, wobei die auf den ersten Pegel angewendete Unterschwingung unmittelbar vor dem ersten Übergang liegt, oder
die auf den zweiten Pegel angewendete Unterschwingung unmittelbar vor dem zweiten Übergang liegt, oder
die auf den zweiten Pegel angewendete Überschwingung unmittelbar vor dem zweiten Übergang liegt, oder
die auf den ersten Pegel angewendete Überschwingung unmittelbar vor dem ersten Übergang liegt.

7. Verfahren nach einem der Ansprüche 1 bis 6, wobei der erste Pegel, der zweite Pegel und der dritte Pegel jeweils die gleiche Polarität haben.

8. Verfahren nach einem der Ansprüche 1 bis 6, wobei ein Pegel aus dem ersten Pegel, dem zweiten Pegel und dem dritten Pegel eine erste Polarität hat und ein weiterer Pegel aus dem ersten Pegel, dem zweiten Pegel und dem dritten Pegel eine zweite Polarität hat, die sich von der ersten Polarität unterscheidet.

9. Verfahren nach einem der Ansprüche 1 bis 8, wobei die nicht-lineare Einrichtung eine Laserdiode (402), eine lichtemittierende Diode, eine Fotodiode, ein Transistor oder ein Verstärker ist.

10. Vorrichtung zur Verarbeitung eines digitalen Signals durch eine nicht-lineare Einrichtung, wobei das digitale Signal einen ersten Übergang von einem ersten Pegel zu einem zweiten Pegel durchläuft, wobei die Vorrichtung umfasst:
einen Voranhebungs-Treiber (401) zur Voranhebung des digitalen Signals; und
eine nicht-lineare Einrichtung (402) zur Verarbeitung des vor-angehobenen digitalen Signals, das von dem Voranhebungs-Treiber (401) ausgegeben wird;
**dadurch gekennzeichnet, dass**
der Voranhebungs-Treiber (401) ausgebildet ist, das digitale Signal voranzuheben durch Anwendung einer Unterschwingung (503) auf den ersten Pegel vor dem ersten Übergang, wenn der erste Pegel niedriger als der zweite Pegel ist; und/oder
das digitale Signal voranzuheben durch Anwendung einer Überschwingung (513) auf den ersten Pegel vor dem ersten Übergang, wenn der erste Pegel höher als der zweite Pegel ist.

11. Vorrichtung nach Anspruch 10, wobei das digitale Signal ferner einen zweiten Übergang im Anschluss an den ersten Übergang von dem zweiten Pegel zu einem dritten Pegel durchläuft, und
der Voranhebungs-Treiber (401) ferner ausgebildet ist, das digitale Signal vor-anzuheben durch Anwendung einer Überschwingung (504, 534-2) auf den zweiten Pegel vor dem zweiten Übergang, wenn der zweite Pegel höher als der dritte Pegel ist; und/oder das digitale Signal vor-anzuheben durch Anwendung einer Unterschwingung (514, 523-2) auf den zweiten Pegel vor dem zweiten Übergang, wenn der zweite Pegel niedriger als der dritte Pegel ist.

12. Vorrichtung nach Anspruch 11, wobei sich der erste Pegel von dem zweiten Pegel unterscheidet.

13. Vorrichtung nach Anspruch 11, wobei der erste Pegel mit dem dritten Pegel übereinstimmt.

14. Vorrichtung nach Anspruch 12 oder 13, wobei das digitale Signal ferner vor dem ersten Übergang einen dritten Übergang von einem vierten Pegel zu dem ersten Pegel durchläuft,
wenn der erste Pegel niedriger als der zweite Pegel ist, ist die vor dem ersten Übergang auf den ersten Pegel angewendete Unterschwingung näher an dem ersten Übergang als an dem dritten Übergang,
wenn der erste Pegel niedriger als der zweite Pegel ist, ist die vor dem zweiten Übergang auf den zweiten Pegel angewendete Überschwingung näher an dem zweiten Übergang als an dem ersten Übergang,
wenn der erste Pegel höher als der zweite Pegel ist, ist die vor dem ersten Übergang auf den ersten Pegel angewendete Überschwingung näher an dem ersten Übergang als an dem dritten Übergang, und
wenn der erste Pegel höher als der zweite Pegel ist, ist die vor dem zweiten Übergang auf den zweiten Pegel angewendete Unterschwingung näher an dem zweiten Übergang als an dem ersten Übergang.

15. Vorrichtung nach einem der Ansprüche 10 bis 14, wobei die auf den ersten Pegel angewendete Unterschwingung unmittelbar vor dem ersten Übergang liegt, oder
die auf den zweiten Pegel angewendete Unterschwingung unmittelbar vor dem zweiten Übergang liegt, oder
die auf den zweiten Pegel angewendete Überschwingung unmittelbar vor dem zweiten Übergang liegt, oder
die auf den ersten Pegel angewendete Überschwingung unmittelbar vor dem ersten Übergang liegt.

16. Vorrichtung nach einem der Ansprüche 11 bis 15, wobei der erste Pegel, der zweite Pegel und der dritte Pegel jeweils die gleiche Polarität haben.

17. Vorrichtung nach einem der Ansprüche 11 bis 15, wobei ein Pegel aus dem ersten Pegel, dem zweiten Pegel und dem dritten Pegel eine erste Polarität hat und ein weiterer Pegel aus dem ersten Pegel, dem zweiten Pegel und dem dritten Pegel eine zweite Polarität hat, die sich von der ersten Polarität unterscheidet.

18. Vorrichtung nach einem der Ansprüche 10 bis 17, wobei die nicht-lineare Einrichtung eine Laserdiode (402), eine lichtemittierende Diode, eine Fotodiode, ein Transistor oder ein Verstärker ist.

19. Sender (400) zum Senden eines digitalen Signals über ein Übertragungsmedium, wobei der Sender die Vorrichtung nach einem der Ansprüche 10 bis 18 aufweist.

20. Sender nach Anspruch 19, wobei die nicht-lineare Einrichtung (402) eine Laserdiode und das Übertragungsmedium eine Lichtleitfaser ist.

21. Kommunikationssystem, das den Sender nach Anspruch 19 oder 20 umfasst.

## Revendications

1. Procédé de traitement d'un signal numérique à travers un dispositif non linéaire, le signal numérique effectuant une première transition d'un premier niveau à un deuxième niveau, le procédé comprenant:
une étape de préaccentuation du signal numérique; et
une étape de traitement du signal numérique préaccentué par le dispositif non linéaire;
**caractérisé en ce que** l'étape de préaccentuation du signal numérique consiste à:
préaccentuer le signal numérique en appliquant un sous-dépassement (503) au premier niveau avant la première transition, lorsque le premier niveau est inférieur au deuxième niveau; et/ou
préaccentuer le signal numérique en appliquant un dépassement (513) au premier niveau avant la première transition, lorsque le premier niveau est supérieur au deuxième niveau.

2. Procédé selon la revendication 1, dans lequel le signal numérique permet en outre une deuxième transition, après la première transition, depuis le deuxième niveau vers un troisième niveau, et
l'étape de préaccentuation du signal numérique consiste en outre à:
préaccentuer le signal numérique en appliquant un dépassement (504, 534-2) au deuxième niveau avant la deuxième transition, lorsque le deuxième niveau est supérieur au troisième niveau; et/ou
préaccentuer le signal numérique en appliquant un sous-dépassement (514, 523-2) au deuxième niveau avant la deuxième transition, lorsque le deuxième niveau est inférieur au troisième niveau.

3. Procédé selon la revendication 2, dans lequel le premier niveau est différent du troisième niveau.

4. Procédé selon la revendication 2, dans lequel le premier niveau coïncide avec le troisième niveau.

5. Procédé selon les revendications 3 ou 4, dans lequel le signal numérique effectue en outre une troisième transition, précédant la première transition, d'un quatrième niveau au premier niveau,
lorsque le premier niveau est inférieur au deuxième niveau, le sous-dépassement appliqué au premier niveau avant la première transition est plus proche de la première transition que de la troisième transition,
lorsque le premier niveau est inférieur au deuxième niveau, le sous-dépassement appliqué au deuxième niveau avant la deuxième transition est plus proche de la deuxième transition que de la première transition,
lorsque le premier niveau est supérieur au deuxième niveau, le sous-dépassement appliqué au premier niveau avant la première transition est plus proche de la première transition que de la troisième transition, et
lorsque le premier niveau est supérieur au deuxième niveau, le sous-dépassement appliqué au deuxième niveau avant la deuxième transition est plus proche de la deuxième transition que de la première transition.

6. Procédé selon l'une quelconque des revendications 1 à 5, dans lequel le sous-dépassement appliqué au premier niveau précède immédiatement la première transition, ou
le sous-dépassement appliqué au deuxième niveau précède immédiatement la deuxième transition, ou le dépassement appliqué au deuxième niveau précède immédiatement la deuxième transition, ou le dépassement appliqué au premier niveau précède immédiatement la première transition.

7. Procédé selon l'une quelconque des revendications 1 à 6, dans lequel l'ensemble du premier niveau, du deuxième niveau et du troisième niveau présente la même polarité.

8. Procédé selon l'une quelconque des revendications 1 à 6, dans lequel un niveau parmi le premier niveau, le deuxième niveau et le troisième niveau présente une première polarité et un autre niveau parmi le premier niveau, le deuxième niveau et le troisième niveau présente une deuxième polarité différente de la première polarité.

9. Procédé selon l'une quelconque des revendications 1 à 8, dans lequel le dispositif non linéaire est un élément parmi une diode laser (402), une diode électroluminescente, une photodiode, un transistor ou un amplificateur.

10. Appareil de traitement d'un signal numérique à travers un dispositif non linéaire, le signal numérique effectuant une première transition d'un premier niveau à un deuxième niveau, le procédé comprenant:
un pilote de préaccentuation (401) pour préaccentuer le signal numérique; et
un dispositif non linéaire (402) pour traiter le signal de sortie numérique préaccentué par le pilote de préaccentuation (401);
**caractérisé en ce que**
le pilote de préaccentuation (401) est adapté pour préaccentuer le signal numérique en appliquant un sous-dépassement (503) au premier niveau avant la première transition, lorsque le premier niveau est inférieur au second niveau; et/ou pour préaccentuer le signal numérique en appliquant un dépassement (513) au premier niveau avant la première transition, lorsque le premier niveau est supérieur au deuxième niveau.

11. Appareil selon la revendication 10, dans lequel le signal numérique effectue en outre une deuxième transition, après la première transition, depuis le deuxième niveau vers un troisième niveau.
le pilote de préaccentuation (401) est en outre prévu pour préaccentuer le signal numérique en appliquant un dépassement (504, 534-2) au deuxième niveau avant la deuxième transition, lorsque le deuxième niveau est supérieur au troisième niveau; et/ou
pour préaccentuer le signal numérique en appliquant un sous-dépassement (514, 523-2) au deuxième niveau avant la deuxième transition, lorsque le deuxième niveau est inférieur au troisième niveau.

12. Appareil selon la revendication 11, dans lequel le premier niveau est différent du troisième niveau.

13. Appareil selon la revendication 11, dans lequel le premier niveau coïncide avec le troisième niveau.

14. Appareil selon les revendications 12 ou 13, dans lequel le signal numérique effectue en outre une troisième transition, précédant la première transition, d'un quatrième niveau au premier niveau,
lorsque le premier niveau est inférieur au deuxième niveau, le sous-dépassement appliqué au premier niveau avant la première transition est plus proche de la première transition que de la troisième transition,
lorsque le premier niveau est inférieur au deuxième niveau, le sous-dépassement appliqué au deuxième niveau avant la deuxième transition est plus proche de la deuxième transition que de la première transition,
lorsque le premier niveau est supérieur au deuxième niveau, le sous-dépassement appliqué au premier niveau avant la première transition est plus proche de la première transition que de la troisième transition, et
lorsque le premier niveau est supérieur au deuxième niveau, le sous-dépassement appliqué au deuxième niveau avant la deuxième transition est plus proche de la deuxième transition que de la première transition.

15. Appareil selon l'une quelconque des revendications 10 à 14, dans lequel le sous-dépassement appliqué au premier niveau précède immédiatement la première transition, ou
le sous-dépassement appliqué au deuxième niveau précède immédiatement la deuxième transition, ou le dépassement appliqué au deuxième niveau précède immédiatement la deuxième transition, ou le dépassement appliqué au premier niveau précède immédiatement la première transition.

16. Appareil selon l'une quelconque des revendications 11 à 15, dans lequel l'ensemble du premier niveau, du deuxième niveau et du troisième niveau présente la même polarité.

17. Appareil selon l'une quelconque des revendications 11 à 15, dans lequel un niveau parmi le premier niveau, le deuxième niveau et le troisième niveau présente une première polarité et un autre niveau parmi le premier niveau, le deuxième niveau et le troisième niveau présente une deuxième polarité différente de la première polarité.

18. Appareil selon l'une quelconque des revendications 10 à 17, dans lequel le dispositif non linéaire est un élément parmi une diode laser (402), une diode électroluminescente, une photodiode, un transistor ou un amplificateur.

19. Emetteur (400) pour transmettre un signal numérique par le biais d'support de transmission incluant l'appareil selon l'une quelconque des revendications 10 à 18.

20. Emetteur selon la revendication 19, dans lequel le dispositif non linéaire (402) est une diode laser et le support de transmission est une fibre optique.

21. Système de communication comprenant l'émetteur selon les revendications 19 ou 20.
